# EUROPEAN PATENT SPECIFICATION

(11) **EP 2 736 072 B1**
(45) Date of publication and mention of the grant of the patent: **11.01.2017**
(21) Application number: 12818128.6
(22) Date of filing: 30.05.2012
(51) Int. Cl.: H01L 27/06, H01L 29/78, H01L 29/06

(54) **SUPERJUNCTION SEMICONDUCTOR DEVICE**
SUPERJUNCTION-HALBLEITERVORRICHTUNG
DISPOSITIF SEMICONDUCTEUR À SUPERJONCTION

(30) Priority: 22.07.2011 JP 2011160756
(43) Date of publication of application: 28.05.2014
(73) Proprietor: Fuji Electric Co., Ltd., Kawasaki-shi, Kanagawa 210-9530 (JP)
(72) Inventor: CAO, Dawei, Kawasaki-shi, Kanagawa 210-9530 (JP); ONISHI, Yasuhiko, Kawasaki-shi, Kanagawa 210-9530 (JP)
(74) Representative: MERH-IP Matias Erny Reichl Hoffmann Patentanwälte PartG mbB
(86) International application number: PCT/JP2012/064007
(87) International publication number: WO 2013/015014

(56) References cited:
- JP-A- 6 117 942
- JP-A- H0 334 360
- JP-A- H08 236 709
- JP-A- 2002 190 575
- JP-A- 2006 313 892
- JP-A- 2006 324 432
- JP-A- 2009 147 297
- US-A1- 2002 074 596
- US-A1- 2005 017 292
- US-A1- 2007 001 230
- US-A1- 2009 291 520

## Description

### TECHNICAL FIELD

The present invention relates to a superjunction semiconductor device having a superjunction structure, and more particularly, to a superjunction semiconductor device including a temperature detecting device.

### BACKGROUND ART

In a general vertical MOSFET (Metal oxide semiconductor field effect transistor), since the on and off operations are repeatedly performed, switching loss or conduction loss occurs and the temperature of a device increases. When the temperature of the device is higher than the allowable temperature, thermal breakdown occurs. Therefore, it is preferable to have a function of rapidly detecting the temperature of the device, applying the detected temperature to a current, and protecting the device from the above-described thermal breakdown.

As a method of detecting the temperature of the semiconductor device, a method has been known which uses a diode as a temperature detecting device. The temperature detecting method detects a potential difference between both terminals of the diode, that is, the forward voltage drop (hereinafter, simply referred to as a forward voltage (VF)) when a forward current flows from a constant current source to the diode which is used as the temperature detecting device. In general, it has been known that the diode has the forward voltage-temperature characteristics in which the forward voltage is linearly changed when the temperature (junction temperature) of the device is changed. Therefore, when the forward voltage of the diode is detected, it is possible to calculate the junction temperature of the device from the detected forward voltage (VF). When the detected junction temperature is higher than the allowable temperature, the gate voltage of the device is reduced to limit the operating current, thereby protecting the device from thermal breakdown.

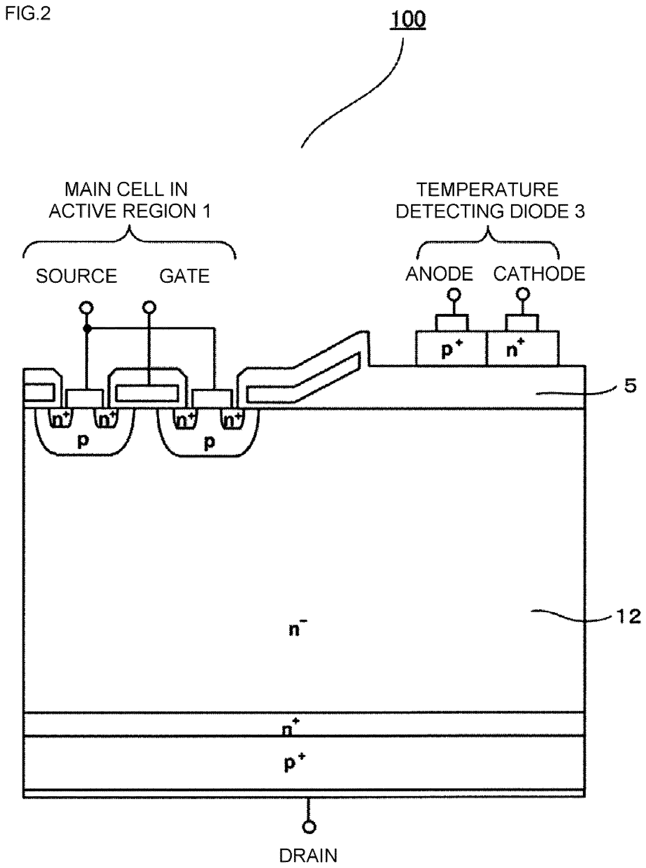

An IGBT (insulated gate bipolar transistor) will be described as an exemplary structure of a MOS (insulated gate having a metal-oxide film-semiconductor structure) semiconductor device including a temperature detecting device according to the related art. Fig. 2 is a cross-sectional view illustrating a main portion of the structure of the MOS semiconductor device including the temperature detecting device according to the related art. Fig. 2 is a cross-sectional view illustrating the end of a MOS semiconductor device 100. As illustrated in Fig. 2, the MOS semiconductor device 100 has been known with a temperature detection structure, which is a diode (in Fig. 2, a temperature detecting diode) 3 provided above the surface of a portion of an n⁻ drift layer 12 in an active region 1, with an insulating film 5 interposed therebetween (for example, see the following Patent Document 1).

In addition, a superjunction semiconductor device having a superjunction (hereinafter, sometimes abbreviated to as SJ) structure has been known. The SJ structure has a parallel structure (hereinafter, referred to as a parallel pn layer) in which p-type regions and n-type regions which extend in a direction perpendicular to the main surface of a substrate and have a small width in a direction parallel to the main surface of the substrate are alternately arranged in an n⁻ drift layer in the direction parallel to the main surface of the substrate. Even when each of the p-type regions and the n-type regions forming the parallel pn layer is a low-resistivity region with high impurity concentration, the width of each region is so small that a depletion layer which is spread from the pn junction between all of p-type regions and the n-type regions in the parallel pn layer rapidly depletes the entire parallel pn layer at a low breakdown voltage when the semiconductor device is turned off. Therefore, it has been known that the SJ structure can obtain both low on-resistance and high breakdown voltage characteristics at the same time (for example, see the following Patent Document2).

In Patent Document 3, a temperature detecting diode is formed near a power MOSFET. The temperature detecting diode comprises a p⁺⁻-type polysilicon which is an anode region of high impurity concentration, an n⁺-type polysilicon which is a cathode region of high impurity concentration, and a p-type polysilicon which is an anode region of relatively low impurity concentration formed between the regions. Thereby, it is an object to provide a semiconductor device comprising a function which accurately detects the temperature of a semiconductor element or its vicinity.

In Patent Document 4, a vertical power semiconductor device that facilitates a high breakdown voltage and a high current capacity such as MOSFET or IGBT are described. Specifically, the method of manufacturing such semiconductor devices is described.

In Patent Document 5, a vertical field effect transistor main body is composed of basic cells arranged in parallel where the gates and the sources of the basic cells are connected to a gate terminal and a source terminal through an aluminum wire or the like. A temperature detecting diode is arranged at the center of a chip so as to be enhanced in temperature detection accuracy.

### CITATION LIST

### PATENT DOCUMENT

Patent Document 1: JP 6-117942 A
Patent Document 2: JP 2006-324432 A
Patent Document 3: JP 2002-190575 A
Patent Document 4: US 2005/017292 A
Patent Document 5: JP H03 34360 A

### DISCLOSURE OF THE INVENTION

### PROBLEM TO BE SOLVED BY THE INVENTION

However, when the IGBT (insulated gate bipolar transistor) temperature detection structure disclosed in Patent Document 1 described above is applied to the SJ-MOSFET disclosed in Patent Document 2, there is a concern that the breakdown voltage will be reduced in a portion of the parallel pn layer immediately below the temperature detection structure. Specifically, since the drift layer of the SJ-MOSFET has a higher impurity concentration than the drift layer of the general MOSFET without the parallel pn layer, it is difficult to deplete the p-type region of the parallel pn layer immediately below the temperature detection structure, particularly, the p-type region which is arranged immediately below the temperature detection structure and comes into contact with the insulating film provided on surface of the parallel pn layer. The inventors studied and found that the breakdown voltage was likely to be reduced due to the difficulty in depletion.

The invention has been made in view of the above-mentioned problems of the related art and an object of the invention is to provide a superjunction semiconductor device capable of preventing thermal breakdown and a reduction in breakdown voltage.

### MEANS FOR SOLVING PROBLEM

In order to solve the above-mentioned problems and achieve the object of the invention, according to an aspect of the invention, a superjunction semiconductor device according to claim 1 is provided.

In the superjunction semiconductor device according to the above-mentioned aspect of the invention, the active region may include an insulated gate structure, and the insulating film provided on the surface of the parallel pn layer in the temperature detection region may be thicker than a gate insulating film forming the insulated gate structure.

The superjunction semiconductor device according to the above-mentioned aspect of the invention may further include an edge termination region that is arranged in the outer circumference of the active region so as to surround the active region and holds a breakdown voltage. The insulating film provided on the surface of the parallel pn layer in the temperature detection region may have the same thickness as a field insulating film which protects a surface of the edge termination region.

In the superjunction semiconductor device according to the above-mentioned aspect of the invention, a plane pattern of the parallel pn layer in the temperature detection region may have a stripe shape which extends in a direction perpendicular to a direction in which the first-conductivity-type semiconductor region and the second-conductivity-type semiconductor region are arranged.

In the superjunction semiconductor device according to the above-mentioned aspect of the invention, a plane pattern of the parallel pn layer in the active region may have the stripe shape which extends in the direction perpendicular to the direction in which the first-conductivity-type semiconductor region and the second-conductivity-type semiconductor region are arranged, and the stripe-shaped plane pattern of the parallel pn layer in the temperature detection region may be parallel or perpendicular to the stripe-shaped plane pattern of the parallel pn layer in the active region.

In the superjunction semiconductor device according to the above-mentioned aspect of the invention, the parallel pn layer in the temperature detection region may have a plane pattern in which the second-conductivity-type semiconductor regions are arranged in a matrix in the first-conductivity-type semiconductor region.

In the superjunction semiconductor device according to the above-mentioned aspect of the invention, the temperature detecting device may be made of polysilicon.

According to the invention, the fine SJ cell with a pitch less than that of the main SJ cell is provided as the drift layer below the temperature detecting device in the temperature detection region, with the insulating film interposed therebetween. Therefore, it is possible to obtain a superjunction semiconductor device including a temperature detecting device which can prevent a reduction in breakdown voltage. In addition, since the superjunction semiconductor device includes the temperature detecting device, it is possible to rapidly detect the temperature of a device, apply the detected temperature to a current, and protect the device from thermal breakdown.

### EFFECT OF THE INVENTION

According to the superjunction semiconductor device of the invention, it is possible to provide a superjunction semiconductor device capable of preventing thermal breakdown and a reduction in breakdown voltage.

### BRIEF DESCRIPTION OF DRAWINGS

Fig. 1 is a cross-sectional view illustrating the structure of a superjunction semiconductor device according to a first embodiment of the invention;
Fig. 2 is a cross-sectional view illustrating a main portion of the structure of a MOS semiconductor device including a temperature detecting device according to the related art;
Fig. 3 is a plan view illustrating the structure of the superjunction semiconductor device according to the first embodiment of the invention;
Fig. 4 is a plan view illustrating the structure of a superjunction semiconductor device according to a second embodiment of the invention; and
Fig. 5 is a plan view illustrating the structure of a superjunction semiconductor device according to a third embodiment of the invention.

### BEST MODE(S) FOR CARRYING OUT THE INVENTION

Hereinafter, vertical superjunction semiconductor devices having a superjunction (SJ) structure according to exemplary embodiments of the invention will be described in detail with reference to the accompanying drawings. In the specification and the accompanying drawings, in the layers or regions having "n" or "p" appended thereto, an electron or a hole means a major carrier. In addition, symbols "+" and "-" added to n or p mean that impurity concentration is higher and lower than that of the layers or the regions without the symbols. In the description of the following embodiments and the accompanying drawings, the same components are denoted by the same reference numerals and the description thereof will not be repeated. In the following description, a first-conductivity-type is an n type and a second-conductivity-type is a p type. The invention is not limited to the following embodiments as long as it does not depart from the scope thereof.

### (First Embodiment)

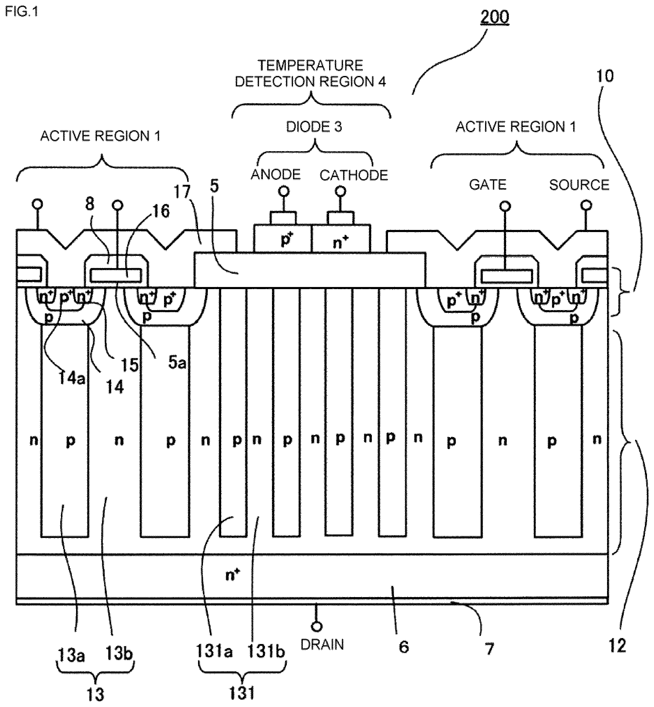

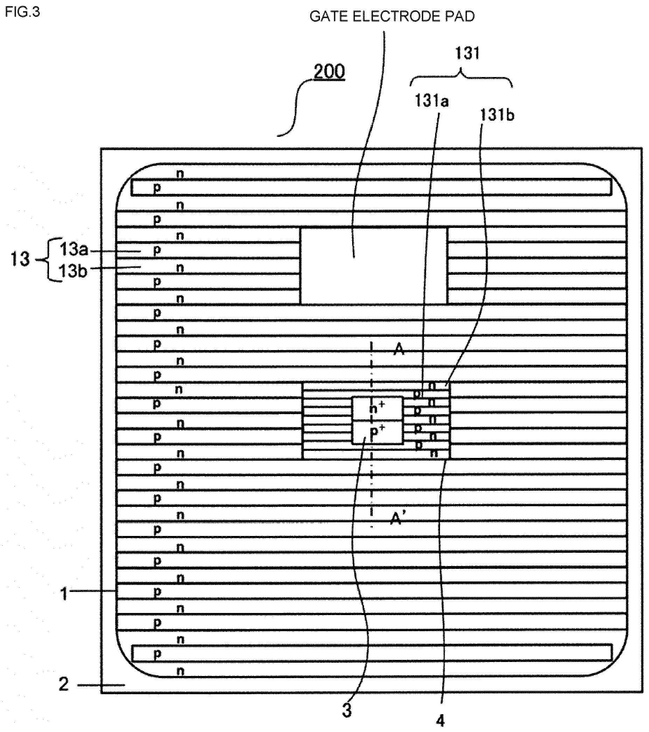

Hereinafter, an SJ-MOSFET will be described in detail as an example of a superjunction semiconductor device according to a first embodiment of the invention. Fig. 1 is a cross-sectional view illustrating the structure of the superjunction semiconductor device according to the first embodiment of the invention. Fig. 3 is a plan view illustrating the structure of the superjunction semiconductor device according to the first embodiment of the invention. Fig. 1 is a cross-sectional view cut along the line A-A' of Fig. 3. In Figs. 1 and 3, the same components as those in Fig. 2 are denoted by the same reference numerals. The superjunction semiconductor device according to the first embodiment of the invention illustrated in Figs. 1 and 3 is an SJ-MOSFET 200 including a temperature detecting device. The SJ-MOSFET 200 includes an active region 1 in which a MOS gate structure 10 is provided and a temperature detection region 4 in which the temperature detecting device (hereinafter, referred to as a temperature detecting diode 3), which is a diode 3, is provided, and the active region 1 and the temperature detection region 4 are provided on the same n⁺ semiconductor substrate 6.

In the SJ-MOSFET 200, a drift layer 12 is a parallel pn layer (SJ cell) in which n-type regions (hereinafter, referred to as n drift regions) and p-type regions (hereinafter, referred to as p partition regions) with high impurity concentration are alternately arranged. Main SJ cells 13 are provided in a portion of the drift layer 12 below the MOS gate structure 10 in the active region 1. The temperature detection region 4 is provided in the active region 1. In the temperature detection region 4, fine SJ cells 131 are provided at a pitch less than the pitch of the main SJ cells 13 in a portion of the drift layer 12 which is below the temperature detecting diode 3 with an insulating film 5 interposed therebetween. Fig. 3 is a plan view illustrating the entire SJ-MOSFET 200 including the temperature detecting diode 3 according to the first embodiment of the invention. In the plan view of Fig. 3, the MOS gate structure 10, and a metal film (except for a gate electrode pad) and an insulating film on the surface of the parallel pn layer are not illustrated in order to clarify the plane pattern of the parallel pn layer (the main SJ cells 13 and the fine SJ cells 131) of the SJ-MOSFET 200.

As illustrated in Fig. 1, the SJ-MOSFET 200 includes the n⁺ semiconductor substrate 6 with low resistance (high impurity concentration) and the parallel pn layer (the main SJ cells 13 and the fine SJ cells 131) which is formed on the surface of the n⁺ semiconductor substrate 6. The main SJ cells 13 are formed in the active region 1 and the fine SJ cells 131 are formed in the temperature detection region 4. The n⁺ semiconductor substrate 6 with low resistance functions as an n⁺ drain region and a metal electrode formed on the backside surface of the n⁺ drain region functions as a drain electrode 7. Similarly to the related art, a solderable laminated metal film, such as a titanium (Ti)-nickel (Ni)-gold (Au) film, is formed as the drain electrode 7 by, for example, a sputtering method or a vapor deposition method. In the SJ structure, it is possible to reduce an on voltage and increase a breakdown voltage by setting the width of regions on both sides of each pn junction between n drift regions 13b and 131b and p partition regions 13a and 131a with high impurity concentration in a direction in which the regions are arranged (hereinafter, simply referred to as a width) such that a depletion layer is rapidly spread from each pn junction to the regions on both sides of the pn junction and the regions on both sides of the pn junction are fully depleted at a low voltage when the semiconductor device is turned off.

The invention is characterized in that the pitch of the main SJ cells 13 is different from that of the fine SJ cells 131. That is, the pitches of the p partition regions and the n drift regions forming each cell are different in the main SJ cell 13 and the fine SJ cell 131. Specifically, the width of the p partition region 131a and the n drift region 131b in the fine SJ cell 131 is less than that of the p partition region 13a and the n drift region 13b in the main SJ cell 13. The reason why the pitch of each region in the fine SJ cell 131 is less than that of each region in the main SJ cell 13 is to prevent a reduction in breakdown voltage. That is, for example, the n drift region 131b and the p partition region 131a of the parallel pn layer in the temperature detection region 4 have the same width or the same arrangement pitch as the n drift region 13b and the p partition region 13a of the parallel pn layer in the active region 1. In the structure in which the insulating film 5 which extends to a surface of the parallel pn layer opposite to the n⁺ semiconductor substrate 6 and comes into contact with the surface is provided between the temperature detecting diode 3 and the parallel pn layer, a portion (the uppermost portion) of the parallel pn layer which comes into contact with the insulating film 5 is not fully depleted. As a result, the electric field is likely to be concentrated on the portion which is not depleted and the breakdown voltage is reduced. For this reason, the fine SJ cells 131 are provided in the above-mentioned structure.

As illustrated in Fig. 1, the main SJ cell 13 includes the n drift region 13b and the p partition region 13a which are arranged adjacent to each other in a direction parallel to the main surface of the n⁺ semiconductor substrate 6. As illustrated in Fig. 1, the fine SJ cell 131 includes the n drift region 131b and the p partition region 131a which are arranged adjacent to each other in the direction parallel to the main surface of the n⁺ semiconductor substrate 6. The n drift regions 13b and 131b and the p partition regions 13a and 131a have a layer shape or a columnar shape which has a small width and extends in a direction perpendicular to the main surface of the n⁺ semiconductor substrate 6. As illustrated in Fig. 3, the plane pattern of the n drift region 13b and the p partition region 13a in the active region 1 has, for example, a stripe shape which extends in a direction perpendicular to the direction in which the drift region 13b and the p partition region 13a are arranged. As illustrated in Fig. 3, the plane pattern of the n drift region 131b and the p partition region 131a in the temperature detection region 4 also has a stripe shape which extends in a direction perpendicular to the direction in which the n drift region 131b and the p partition region 131a are arranged.

The n drift region 131b and the p partition region 131a in the temperature detection region 4 are parallel to the n drift region 13b and the p partition region 13a in the active region 1. It is preferable that the pitch of the stripe-shaped plane pattern of the n drift region 131b and the p partition region 131a be half the pitch of the stripe-shaped plane pattern of the n drift region 13b and the p partition region 13a in the active region 1. The reason is as follows. The mutual diffusion between the n drift region 131b and the p partition region 131a in the temperature detection region 4 is large and impurity concentration is compensated, which makes it possible to reduce the impurity concentration of both regions. As a result, the depletion layer is easily spread. In addition, the directions in which the stripe-shaped plane pattern of each parallel pn layer extends in the active region 1 and the temperature detection region 4 are parallel to each other. In Fig. 3, a white rectangular region which is illustrated on the upper side of the temperature detection region 4 in the active region 1 is a gate electrode pad portion. In addition, in Fig. 3, an edge termination region 2 which reduces the electric field of the end of the active region 1 to hold the breakdown voltage is provided so as to surround the outer circumference of the active region 1. Since the edge termination region 2 is the same as the edge termination region of the MOSFET according to the related art, the detailed description thereof will not be made.

In the active region 1, similarly to the general MOSFET, a p base region 14 is provided in a surface layer of each p partition region 13a opposite to the n⁺ semiconductor substrate 6. An n⁺ source region 15 and a high-concentration p⁺ contact region 14a are provided in the p base region 14 so as to be exposed from the surface of the parallel pn layer opposite to the n⁺ semiconductor substrate 6. A gate electrode 16, which is a polysilicon film, is provided above a portion of the p base region 14 interposed between the n⁺ source region 15 and the n drift region 13b, with a gate insulating film 5a interposed therebetween. A source electrode 17, which is a metal film having aluminum (Al) as a main component, is provided on the surface of the n⁺ source region 15 and the p⁺ contact region 14a so as to come into contact therewith. The gate electrode 16 is covered with an interlayer insulating film 8 to be electrically insulated from the source electrode 17 which covers the interlayer insulating film 8.

In the temperature detection region 4, the temperature detecting diode 3 is formed on the surface of the fine SJ cell 131 opposite to the n⁺ semiconductor substrate 6 with the thick insulating film 5 interposed therebetween. The temperature detecting diode 3 includes a p⁺ anode region and an n⁺ cathode region which are laminated so as to come into contact with the surface of the insulating film 5 and a pn junction is formed between the two regions. In addition, an anode electrode is provided on the surface of the p⁺ anode region and a cathode electrode is provided on the surface of the n⁺ cathode region. It is preferable that the insulating film 5 be as thick as possible in order to prevent the interference between the temperature detecting diode 3 and the fine SJ cell 131. For example, it is preferable that an oxide film that is formed at the same time as a field oxide film formed as a protective film on the surface of the drift layer of the edge termination region 2 (not illustrated in Fig. 1) be used as the insulating film 5. In this case, the insulating film 5 has the same thickness as the thick field oxide film.

As such, the temperature detecting diode 3 is formed while being electrically insulated from the fine SJ cell 131 by the insulating film 5. However, even when the temperature detecting diode 3 is electrically insulated from the fine SJ cell 131, there is a concern that depletion will be insufficient since, for example, the field plate effect of the edge termination region 2 affects the parallel pn layer (fine SJ cell 131) immediately below the insulating film 5. As described above, when the pitch between the fine SJ cells 131 below the temperature detecting diode 3 in the temperature detection region 4 is less than the pitch between the main SJ cells 13 in the active region 1, the effect of preventing reduction in the breakdown voltage is obtained. As a result, in the fine SJ cell 131 in the temperature detection region 4, the depletion layer is more likely to be spread by an off-state voltage than in the main SJ cell 13 in the active region 1. Therefore, in the SJ-MOSFET 200 according to the first embodiment, a reduction in the breakdown voltage which has occurred in the SJ-MOSFET according to the related art is prevented and a high breakdown voltage is obtained. In addition, the p base region 14 is not formed in the upper part of the fine SJ cell 131 in the temperature detection region 4, unlike the main SJ cell 13. In this way, the length of the fine SJ cell 131 in the direction perpendicular to the main surface of the n⁺ semiconductor substrate 6 is more than that of the main SJ cell 13 by a value corresponding to the p base region 14. Therefore, it is expected to obtain a higher breakdown voltage than that in the active region 1. In addition, since a process for forming the p base region 14 in the temperature detection region 4 is not needed, it is possible to reduce manufacturing costs. As illustrated in Fig. 3, the temperature detection region 4 may not be provided at the center of the active region 1. That is, the temperature detection region 4 may be provided at any position of the active region 1.

### (Second Embodiment)

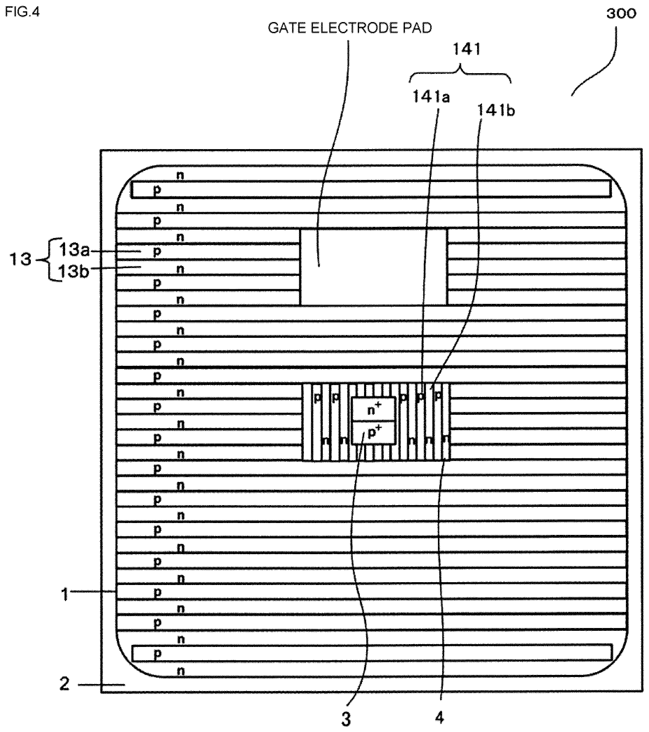

Fig. 4 is a plan view illustrating the structure of a superjunction semiconductor device according to a second embodiment of the invention. An SJ-MOSFET 300 according to the second embodiment differs from the SJ-MOSFET 200 according to the first embodiment in that the stripe-shaped plane pattern of the temperature detection region 4 is perpendicular to the stripe-shaped plane pattern of the active region 1. As illustrated in Fig. 4, a fine SJ cell 141 in the temperature detection region 4 is similar to the fine SJ cell illustrated in Fig. 3 in that it has a stripe-shaped plane pattern which extends in a direction perpendicular to the direction in which an n drift region 141b and a p partition region 141a are arranged. The fine SJ cell 141 differs from the fine SJ cell illustrated in Fig. 3 in that the direction in which the stripe of the plane pattern of the fine SJ cell 141 extends is perpendicular to the direction in which the stripe of the plane pattern of the main SJ cell 13 in the active region 1 extends. In the structure of the fine SJ cell illustrated in Fig. 4, the same effect as that in the first embodiment is obtained. When the stripe-shaped plane patterns of the fine SJ cell 141 and the main SJ cell 13 are perpendicular to each other, flexibility in the design of the pitch between the SJ cells is improved. Therefore, it is easy to reduce the pitch and increase the breakdown voltage.

### (Third Embodiment)

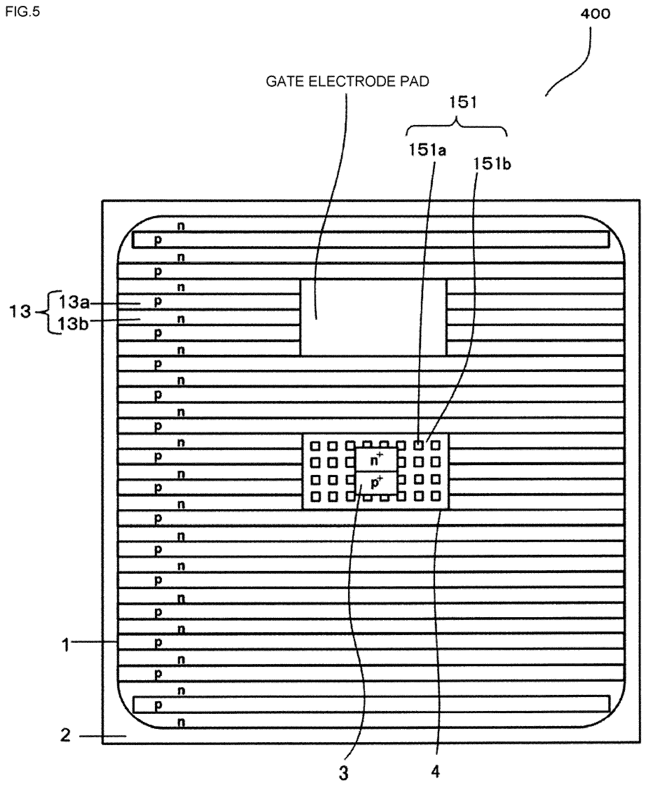

Fig. 5 is a plan view illustrating the structure of a superjunction semiconductor device according to a third embodiment of the invention. An SJ-MOSFET 400 according to the third embodiment differs from the SJ-MOSFETs 200 and 300 according to the first and second embodiments in that fine SJ cells 151 in the temperature detection region 4 have a lattice-shaped plane pattern. The lattice-shaped plane pattern means a plane pattern in which p partition regions 151a having a rectangular shape in a plan view are arranged in a matrix in an n drift region 151b. In the third embodiment, the pitch of the lattice-shaped plane pattern of the fine SJ cells 151 is less than that of the stripe-shaped plane pattern of the main SJ cells 13. Therefore, the same effect as that in the first embodiment is obtained.

As described above, according to each embodiment, in the temperature detection region, the drift layer including the fine SJ cells which are arranged at a pitch less than that of the main SJ cells is provided below the temperature detecting diode, with the insulating film interposed therebetween. In this way, it is possible to obtain a superjunction semiconductor device including a temperature detecting device which prevents a reduction in the breakdown voltage. In addition, since the superjunction semiconductor device can include the temperature detecting device, it is possible to rapidly detect the device temperature, apply the detected device temperature to the on current, and protect the device from thermal breakdown. Therefore, it is possible to provide a superjunction semiconductor device capable of preventing thermal breakdown and a reduction in the breakdown voltage.

In the above-described embodiments of the invention, the SJ-MOSFET has been described as an example, but the invention is not limited to the above-described embodiments. For example, the invention can be applied to various superjunction semiconductor devices including the temperature detecting diode. In each of the above-described embodiments, the first-conductivity-type is an n type and the second-conductivity-type is a p type. However, the first-conductivity-type may be a p type and the second-conductivity-type may be an n type. In this case, the same effect as described above is obtained.

### INDUSTRIAL APPLICABILITY

As described above, the superjunction semiconductor device according to the invention is effective for a power semiconductor device which is used in, for example, a switching device that is repeatedly turned on and off.

### EXPLANATIONS OF LETTERS OR NUMERALS

- 1: ACTIVE REGION
- 2: EDGE TERMINATION REGION
- 3: TEMPERATURE DETECTING DIODE
- 4: TEMPERATURE DETECTION REGION
- 5: INSULATING FILM
- 6: n⁺ SEMICONDUCTOR SUBSTRATE
- 7: DRAIN ELECTRODE
- 8: INTERLAYER INSULATING FILM
- 10: MOS GATE STRUCTURE
- 12: DRIFT LAYER
- 13: MAIN SJ CELL
- 13a: p PARTITION REGION
- 13b: n DRIFT REGION
- 14: p BASE REGION
- 15: n⁺ SOURCE REGION
- 16: GATE ELECTRODE
- 17: SOURCE ELECTRODE
- 131, 141, 151: FINE SJ CELL
- 131a, 141a, 151a: p PARTITION REGION
- 131b, 141b, 151b: n DRIFT REGION
- 200, 300, 400: SJ-MOSFET

## Claims

1. A superjunction semiconductor device comprising:
a drift layer (12) serving as a parallel pn layer in which a first-conductivity-type semiconductor region (13b) and a second-conductivity-type semiconductor region (13a) extending in a direction perpendicular to a main surface of a first-conductivity-type semiconductor substrate (6) with a high impurity concentration are alternately arranged at a pitch in a direction parallel to the main surface of the semiconductor substrate (6) so as to be adjacent to each other;
an active region (1) that serves as a main current path, wherein in the active region (1) a pitch between the first-conductivity type semiconductor region (13b) and the second-conductivity-type semiconductor region (13a) of the parallel pn layer is a first pitch;
a temperature detection region (4) which is provided in the active region (1) and wherein in the temperature detection region (4) a pitch between the first-conductivity-type semiconductor region (131b) and the second-conductivity-type semiconductor region (131a) of the parallel pn layer is less than the first pitch;
a first-conductivity-type semiconductor layer that is provided above a surface of the parallel pn layer in the temperature detection region (4) with an insulating film (5) interposed therebetween;
a second-conductivity-type semiconductor layer that is provided above the surface of the parallel pn layer in the temperature detection region (4) with the insulating film (5) interposed therebetween and is arranged so as to come into contact with the first-conductivity-type semiconductor layer to form a pn junction; and
a temperature detecting device (3) that is a semiconductor layer including the first-conductivity-type semiconductor layer and the second-conductivity-type semiconductor layer,
wherein a current flows to the first-conductivity-type semiconductor region (13b) in an on-state of the superjunction semiconductor device and the parallel pn layer is depleted in an off-state of the superjunction semiconductor device to sustain a reverse blocking voltage.

2. The superjunction semiconductor device according to claim 1,
wherein the active region (1) includes an insulated gate structure, and
the insulating film (5) provided on the surface of the parallel pn layer in the temperature detection region (4) is thicker than a gate insulating film forming the insulated gate structure.

3. The superjunction semiconductor device according to claim 2, further comprising:
an edge termination region (2) that is provided in the outer circumference of the active region (1) so as to surround the active region (1) and sustains a breakdown voltage,
wherein the insulating film (5) provided on the surface of the parallel pn layer in the temperature detection region (4) has the same thickness as a field insulating film which protects a surface of the edge termination region (2).

4. The superjunction semiconductor device according to claim 1,
wherein a plane pattern of the parallel pn layer in the temperature detection region (4) has a stripe shape which extends in a direction perpendicular to a direction in which the first-conductivity-type semiconductor region (13b) and the second-conductivity-type semiconductor region (13a) are arranged.

5. The superjunction semiconductor device according to claim 4,
wherein a plane pattern of the parallel pn layer in the active region (1) has the stripe shape which extends in the direction perpendicular to the direction in which the first-conductivity-type semiconductor region (13b) and the second-conductivity-type semiconductor region (13a) are arranged, and
the stripe-shaped plane pattern of the parallel pn layer in the temperature detection region (4) is parallel to the stripe-shaped plane pattern of the parallel pn layer in the active region (1).

6. The superjunction semiconductor device according to claim 4,
wherein a plane pattern of the parallel pn layer in the active region (1) has the stripe shape which extends in the direction perpendicular to the direction in which the first-conductivity-type semiconductor region (13b) and the second-conductivity-type semiconductor region (13a) are arranged, and
the stripe-shaped plane pattern of the parallel pn layer in the temperature detection region is perpendicular to the stripe-shaped plane pattern of the parallel pn layer in the active region (1).

7. The superjunction semiconductor device according to claim 1,
wherein the parallel pn layer in the temperature detection region (4) has a plane pattern in which the second-conductivity-type semiconductor regions (13a) are arranged in a matrix in the first-conductivity-type semiconductor region (13b).

8. The superjunction semiconductor device according to any one of claims 1 to 7,
wherein the temperature detecting device (3) is made of polysilicon.

## Patentansprüche

1. Superjunction-Halbleitervorrichtung, die umfasst:
eine Driftschicht (12), die als parallele pn-Schicht dient, wobei eine Halbleiterregion (13b) eines ersten Leitfähigkeitstyps und eine Halbleiterregion (13a) eines zweiten Leitfähigkeitstyps, die sich in einer Richtung lotrecht zu einer Hauptoberfläche eines ersten Halbleitersubstrats (6) eines ersten Leitfähigkeitstyps mit hoher Konzentration von Verunreinigungen erstrecken, abwechselnd in einem Abstand in einer Richtung parallel zur Hauptoberfläche des Halbleitersubstrats (6) angeordnet sind, um einander benachbart zu sein;
eine aktive Region (1), die als Hauptstromweg dient, wobei ein Abstand zwischen der Halbleiterregion (13b) eines ersten Leitfähigkeitstyps und der Halbleiterregion (13a) eines zweiten Leitfähigkeitstyps der parallelen pn-Schicht in der aktiven Region (1) ein erster Abstand ist;
eine Temperaturerkennungsregion (4), die in der aktiven Region (1) bereitgestellt ist, und wobei ein Abstand zwischen der Halbleiterregion (131b) eines ersten Leitfähigkeitstyps und der Halbleiterregion (131a) eines zweiten Leitfähigkeitstyps der parallelen pn-Schicht in der Temperaturerkennungsregion (4) kleiner als der erste Abstand ist;
eine Halbleiterschicht eines ersten Leitfähigkeitstyps, die über einer Oberfläche der parallelen pn-Schicht in der Temperaturerkennungsregion (4) bereitgestellt ist, wobei ein Isolierfilm (5) dazwischen angeordnet ist;
eine Halbleiterschicht eines zweiten Leitfähigkeitstyps, die über der Oberfläche der parallelen pn-Schicht in der Temperaturerkennungsregion (4) bereitgestellt ist, wobei der Isolierfilm (5) dazwischen angeordnet ist, und die so angeordnet ist, dass sie mit der Halbleiterschicht eines ersten Leitfähigkeitstyps in Kontakt gelangt, um einen pn-Übergang zu bilden; und
eine Temperaturerkennungsvorrichtung (3), die eine Halbleiterschicht ist, die die Halbleiterschicht eines ersten Leitfähigkeitstyps und die Halbleiterschicht eines zweiten Leitfähigkeitstyps beinhaltet,
wobei ein Strom zur Halbleiterregion (13b) eines ersten Leitfähigkeitstyps in einem EIN-Status der Superjunction-Halbleitervorrichtung fließt, und die parallele pn-Schicht in einem AUS-Status der Superjunction-Halbleitervorrichtung entleert ist, um eine Sperrspannung aufrechtzuerhalten.

2. Superjunction-Halbleitervorrichtung nach Anspruch 1,
wobei die aktive Region (1) eine isolierte Gate-Struktur beinhaltet, und
der Isolierfilm (5), der auf der Oberfläche der parallelen pn-Schicht in der Temperaturerkennungsregion (4) bereitgestellt ist, dicker als ein Gate-Isolierfilm ist, der die isolierte Gate-Struktur bildet.

3. Superjunction-Halbleitervorrichtung nach Anspruch 2, die des Weiteren umfasst:
eine Randabschlussregion (2), die im Außenumfang der aktiven Region (1) bereitgestellt ist, um die aktive Region (1) zu umgeben, und die eine Durchbruchspannung aufrechterhält,
wobei der Isolierfilm (5), der auf der Oberfläche der parallelen pn-Schicht in der Temperaturerkennungsregion (4) bereitgestellt ist, die gleiche Dicke wie ein Feldisolierfilm aufweist, der eine Oberfläche der Randabschlussregion (2) schützt.

4. Superjunction-Halbleitervorrichtung nach Anspruch 1,
wobei eine ebene Strukturierung der parallelen pn-Schicht in der Temperaturerkennungsregion (4) eine Streifenform aufweist, die sich in einer Richtung lotrecht zu einer Richtung erstreckt, in der die Halbleiterregion (13b) eines ersten Leitfähigkeitstyps und die Halbleiterregion (13a) eines zweiten Leitfähigkeitstyps angeordnet sind.

5. Superjunction-Halbleitervorrichtung nach Anspruch 4,
wobei eine ebene Strukturierung der parallelen pn-Schicht in der aktiven Region (1) die Streifenform aufweist, die sich in der Richtung lotrecht zur Richtung erstreckt, in der die Halbleiterregion (13b) eines ersten Leitfähigkeitstyps und die Halbleiterregion (13a) eines zweiten Leitfähigkeitstyps angeordnet sind, und
die streifenförmige ebene Strukturierung der parallelen pn-Schicht in der Temperaturerkennungsregion (4) parallel zur streifenförmigen ebenen Strukturierung der parallelen pn-Schicht in der aktiven Region (1) verläuft.

6. Superjunction-Halbleitervorrichtung nach Anspruch 4,
wobei eine ebene Strukturierung der parallelen pn-Schicht in der aktiven Region (1) die Streifenform aufweist, die sich in der Richtung lotrecht zur Richtung erstreckt, in der die Halbleiterregion (13b) eines ersten Leitfähigkeitstyps und die Halbleiterregion (13a) eines zweiten Leitfähigkeitstyps angeordnet sind, und
die streifenförmige ebene Strukturierung der parallelen pn-Schicht in der Temperaturerkennungsregion (4) lotrecht zur streifenförmigen ebenen Strukturierung der parallelen pn-Schicht in der aktiven Region (1) verläuft.

7. Superjunction-Halbleitervorrichtung nach Anspruch 1,
wobei die parallele pn-Schicht in der Temperaturerkennungsregion (4) eine ebene Strukturierung aufweist, bei der die Halbleiterregionen (13a) eines zweiten Leitfähigkeitstyps in einer Matrix in der Halbleiterregion (13b) eines ersten Leitfähigkeitstyps angeordnet sind.

8. Superjunction-Halbleitervorrichtung nach einem der Ansprüche 1 bis 7,
wobei die Temperaturerkennungsvorrichtung (3) aus Polysilicium hergestellt ist.

## Revendications

1. Dispositif à semi-conducteurs à super-jonction comprenant :
une couche de dérive (12) servant en tant que couche pn parallèle dans laquelle une région semi-conductrice de premier type de conductivité (13b) et une région semi-conductrice de second type de conductivité (13a) s'étendant dans une direction perpendiculaire à une surface principale d'un substrat semi-conducteur de premier type de conductivité (6) avec une concentration d'impuretés élevée sont disposées de manière alternée à un pas dans une direction parallèle à la surface principale du substrat semi-conducteur (6) afin d'être adjacentes l'une à l'autre ;
une région active (1) qui sert en tant que chemin de courant principal, dans laquelle dans la région active (1) un pas entre la région semi-conductrice de premier type de conductivité (13b) et la région semi-conductrice de second type de conductivité (13a) de la couche pn parallèle est un premier pas ;
une région de détection de température (4) qui est disposée dans la région active (1) et dans laquelle dans la région de détection de température (4) un pas entre la région semi-conductrice de premier type de conductivité (131b) et la région semi-conductrice de second type de conductivité (131a) de la couche pn parallèle est inférieur au premier pas ;
une couche semi-conductrice de premier type de conductivité qui est disposée au-dessus d'une surface de la couche pn parallèle dans la région de détection de température (4) avec un film isolant (5) interposé entre celles-ci ;
une couche semi-conductrice de second type de conductivité qui est disposée au-dessus de la surface de la couche pn parallèle dans la région de détection de température (4) avec le film isolant (5) interposé entre celles-ci et est agencée afin de venir en contact avec la couche semi-conductrice de premier type de conductivité pour former une jonction pn ; et
un dispositif de détection de température (3) qui est une couche semi-conductrice comprenant la couche semi-conductrice de premier type de conductivité et la couche semi-conductrice de second type de conductivité,
dans lequel un courant circule vers la région semi-conductrice de premier type de conductivité (13b) dans un état fermé du dispositif à semi-conducteurs à super-jonction et la couche pn parallèle est appauvrie dans un état ouvert du dispositif à semi-conducteurs à super-jonction afin de maintenir une tension de blocage inverse.

2. Dispositif à semi-conducteurs à super-jonction selon la revendication 1,
dans lequel la région active (1) comprend une structure à grille isolée, et
le film isolant (5) disposé sur la surface de la couche pn parallèle dans la région de détection de température (4) est plus épais qu'un film d'isolation de grille formant la structure à grille isolée.

3. Dispositif à semi-conducteurs à super-jonction selon la revendication 2, comprenant en outre :
une région de terminaison de bord (2) qui est disposée dans la circonférence extérieure de la région active (1) afin d'entourer la région active (1) et maintient une tension de claquage,
dans lequel le film isolant (5) disposé sur la surface de la couche pn parallèle dans la région de détection de température (4) possède la même épaisseur qu'un film d'isolation de champ qui protège une surface de la région de terminaison de bord (2).

4. Dispositif à semi-conducteurs à super-jonction selon la revendication 1,
dans lequel un motif plan de la couche pn parallèle dans la région de détection de température (4) possède une forme de bande qui s'étend dans une direction perpendiculaire à une direction dans laquelle la région semi-conductrice de premier type de conductivité (13b) et la région semi-conductrice de second type de conductivité (13a) sont agencées.

5. Dispositif à semi-conducteurs à super-jonction selon la revendication 4,
dans lequel un motif plan de la couche pn parallèle dans la région active (1) possède la forme de bande qui s'étend dans la direction perpendiculaire à la direction dans laquelle la région semi-conductrice de premier type de conductivité (13b) et la région semi-conductrice de second type de conductivité (13a) sont agencées, et
le motif plan en forme de bande de la couche pn parallèle dans la région de détection de température (4) est parallèle au motif plan en forme de bande de la couche pn parallèle dans la région active (1).

6. Dispositif à semi-conducteurs à super-jonction selon la revendication 4,
dans lequel un motif plan de la couche pn parallèle dans la région active (1) possède la forme de bande qui s'étend dans la direction perpendiculaire à la direction dans laquelle la région semi-conductrice de premier type de conductivité (13b) et la région semi-conductrice de second type de conductivité (13a) sont agencées, et
le motif plan en forme de bande de la couche pn parallèle dans la région de détection de température est perpendiculaire au motif plan en forme de bande de la couche pn parallèle dans la région active (1).

7. Dispositif à semi-conducteurs à super-jonction selon la revendication 1,
dans lequel la couche pn parallèle dans la région de détection de température (4) possède un motif plan dans lequel les régions semi-conductrices de second type de conductivité (13a) sont agencées dans une matrice dans la région semi-conductrice de premier type de conductivité (13b).

8. Dispositif à semi-conducteurs à super-jonction selon l'une quelconque des revendications 1 à 7,
dans lequel le dispositif de détection de température (3) est réalisé en polysilicium.
